(19) **Europäisches Patentamt European Patent Office Office européen des brevets**

(11) **EP 4 742 300 A1**

(12) **EUROPEAN PATENT APPLICATION**
published in accordance with Art. 153(4) EPC

(43) Date of publication:
**13.05.2026  Bulletin 2026/20**

(21) Application number: **24859074.7**

(22) Date of filing: **29.05.2024**

(51) International Patent Classification (IPC):
***H01L 21/304*** (2006.01)

(52) Cooperative Patent Classification (CPC):
**H10P 52/00**

(86) International application number:
**PCT/JP2024/019757**

(87) International publication number:
**WO 2025/047025 (06.03.2025 Gazette 2025/10)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **25.08.2023  PCT/JP2023/030752
25.08.2023  PCT/JP2023/030756**

(71) Applicant: **Resonac Corporation
Tokyo 105-7325 (JP)**

(72) Inventors:
• **MAEDA, Masanori**
**Tokyo 105-7325 (JP)**
• **SAKAGUCHI, Junya**
**Tokyo 105-7325 (JP)**
• **KUBOTA, Shigeki**
**Tokyo 105-7325 (JP)**
• **TAINAKA, Sota**
**Tokyo 105-7325 (JP)**
• **MIZUTANI, Makoto**
**Tokyo 105-7325 (JP)**

(74) Representative: **Hoffmann Eitle
Patent- und Rechtsanwälte PartmbB
Arabellastraße 30
81925 München (DE)**

(54) **SLURRY AND POLISHING METHOD**

(57) A slurry contains abrasive grains and water, in which the abrasive grains include cerium oxide particles, and a product P of a ratio R of a peak intensity of a (200) plane to a peak intensity of a (111) plane in an X-ray diffraction measurement of the cerium oxide particles and a crystallite diameter D of the (111) plane of the cerium oxide particles is 7.5 to 11.0 nm. A polishing method includes a step of polishing a surface to be polished using the slurry.

EP 4 742 300 A1

## Description

## Technical Field

The present disclosure relates to a slurry, a polishing method, and the like.

## Background Art

In recent years, processing techniques for densification and micronization are becoming more important in manufacturing steps for semiconductor elements. A chemical mechanical polishing (CMP) technique that is one of processing techniques has become an essential technique in manufacturing steps for semiconductor elements for formation of shallow trench isolation (hereinafter, referred to as "STI"), flattening of pre-metal insulating materials or interlayer insulating materials, formation of plugs or embedded metal wirings, or the like.

Examples of the most frequently used polishing liquid include a silica-based polishing liquid containing silica (silicon oxide) particles such as fumed silica or colloidal silica as abrasive grains. The silica-based polishing liquid is characterized by being high in versatility, and can polish broad types of materials irrespective of insulating materials and conductive materials by appropriately selecting an abrasive grain content, a pH, additives, or the like.

On the other hand, a demand for a cerium oxide-based polishing liquid containing cerium oxide particles as abrasive grains is expanding. For example, the cerium oxide-based polishing liquid can polish an insulating material at a high rate even when a content of abrasive grains is lower than that in the silica-based polishing liquid (for example, see Patent Literatures 1 and 2 described below).

## Citation List

## Patent Literature

Patent Literature 1: Japanese Unexamined Patent Publication No. H10-106994
Patent Literature 2: Japanese Unexamined Patent Publication No. H08-022970

## Summary of Invention

## Technical Problem

Meanwhile, in recent years, a 3D-NAND device in which a cell portion of the device is stacked in a vertical direction has emerged. In the present technique, the level differences of the insulating materials during cell formation are several times higher compared to the conventional planar types. According to this, in order to maintain the throughput of the device production, it is necessary to rapidly resolve the high level difference as described above in a CMP step or the like, and it is necessary to improve a polishing rate for the insulating material.

An aspect of the present disclosure is to provide a slurry capable of obtaining a high polishing rate for an insulating material. Another aspect of the present disclosure is to provide a polishing method using the slurry.

## Solution to Problem

The present disclosure relates to the following [1] to [9] and the like.

[1] A slurry containing abrasive grains and water,

in which the abrasive grains include cerium oxide particles, and
a product P of a ratio R of a peak intensity of a (200) plane to a peak intensity of a (111) plane in an X-ray diffraction measurement of the cerium oxide particles and a crystallite diameter D of the (111) plane of the cerium oxide particles is 7.5 to 11.0 nm.

[2] The slurry according to [1], in which the ratio R is 0.220 to 0.330.
[3] The slurry according to [1] or [2], in which the ratio R is 0.265 or more.
[4] The slurry according to any one of [1] to [3], in which the crystallite diameter D is 25.0 to 35.0 nm.
[5] The slurry according to any one of [1] to [4], in which the product P is 8.5 to 10.0 nm.

[6] The slurry according to any one of [1] to [5], in which a content of the abrasive grains is 0.01 to 10.00 mass%.

[7] The slurry according to any one of [1] to [6], in which a pH of the slurry is less than 7.00.

[8] The slurry according to any one of [1] to [7], in which the slurry is used for polishing a surface to be polished containing silicon oxide.

[9] A polishing method including a step of polishing a surface to be polished using the slurry according to any one of [1] to [8].

**Advantageous Effects of Invention**

According to an aspect of the present disclosure, it is possible to provide a slurry capable of obtaining a high polishing rate for an insulating material. According to another aspect of the present disclosure is to provide a polishing method using the slurry.

**Description of Embodiments**

Hereinafter, embodiments of the present disclosure will be described in detail.

<Definitions>

In the present specification, a numerical range indicated using "to" indicates a range including numerical values described before and after "to" as a minimum value and a maximum value, respectively. "A or more" of the numerical range means A and a range exceeding A. "A or less" of the numerical range means A and a range less than A. In the numerical range described in stages in the present specification, an upper limit value or a lower limit value of a numerical range of a certain stage can be arbitrarily combined with an upper limit value or a lower limit value of a numerical range of another stage. In the numerical range described in the present specification, the upper limit value or the lower limit value of the numerical range may be replaced with a value shown in Examples. "A or B" may include either A or B, or may include both A and B. The materials exemplified in the present specification can be used alone or in combination of two or more thereof unless otherwise specified. When a plurality of materials corresponding to the respective components are present in the composition, a content of each component in the composition means the total amount of the plurality of materials present in the composition unless otherwise specified. The term "film" includes not only a structure having a shape formed on the entire surface but also a structure having a shape formed on a part thereof when observed as a plan view. The term "step" includes not only an independent step but also a step that cannot be clearly distinguished from other steps as long as the intended action of the step is achieved.

As described below, a slurry according to the present embodiment contains abrasive grains. The abrasive grain is also referred to as an "abrasive particle", and is referred to as an "abrasive grain" in the present specification. The abrasive grains are generally solid particles, and it is considered that an object to be removed is removed by a mechanical action of the abrasive grains and a chemical action of the abrasive grains (mainly the surfaces of the abrasive grains) at the time of polishing, but the present disclosure is not limited thereto.

<Slurry>

A slurry according to the present embodiment contains abrasive grains and water. The slurry according to the present embodiment can be used as, for example, a polishing liquid (CMP polishing liquid). In the present specification, the "polishing liquid" is defined as a composition that comes into contact with a surface to be polished during polishing. The phrase "polishing liquid" itself does not limit all the components contained in the polishing liquid.

In the slurry according to the present embodiment, the abrasive grains include cerium oxide particles, and a product P (ratio R × crystallite diameter D) of a ratio R (peak intensity of (200) plane/peak intensity of (111) plane) of a peak intensity of a (200) plane to a peak intensity of a (111) plane in an X-ray diffraction measurement of the cerium oxide particles and a crystallite diameter D of the (111) plane of the cerium oxide particles is 7.5 to 11.0 nm.

According to the slurry according to the present embodiment, a high polishing rate for an insulating material can be obtained, and for example, a high polishing rate for silicon oxide can be obtained. According to the slurry according to the present embodiment, for example, 450 nm/min or more (preferably, 500 nm/min or more, 600 nm/min or more, 700 nm/min or more, 800 nm/min or more, 900 nm/min or more, or the like) can be obtained as a polishing rate for an insulating material (for example, silicon oxide) in a method for evaluating a blanket wafer described in Examples described below.

According to an aspect of the slurry according to the present embodiment, for example, 100 nm/min or more (preferably, 200 nm/min or more, 300 nm/min or more, 500 nm/min or more, 800 nm/min or more, 1,000 nm/min or more, 1,200 nm/min or more, 1,400 nm/min or more, 1,500 nm/min or more, or the like) can be obtained as a polishing rate for an insulating material (for example, silicon oxide) in a method for evaluating a patterned wafer described in Examples described below.

A factor by which a high polishing rate for an insulating material can be obtained is not necessarily clear, but is presumed to be as follows. However, the factor is not limited to the following content.

That is, first, as for the ratio R of the peak intensity of the (200) plane to the peak intensity of the (111) plane of the cerium oxide particles, as the value of the ratio R increases, the (200) plane in which the reactivity of the particles with the insulating material is high is superior to the (111) plane, and therefore, chemical polishing performance is improved. However, as the value of the ratio R decreases, the (111) plane in which the physical intensity of the particles is high is superior to the (200) plane, and therefore, physical polishing performance is improved. In addition, as for the crystallite diameter D of the (111) plane of the cerium oxide particles, as the crystallite diameter D increases, the number of grain boundaries decreases, and the particles are less likely to crack with the progress of polishing, such that physical polishing performance is improved. However, when the crystallite diameter D is too large, the particles become too hard, such that the particles are less likely to crack, and a new crystal plane having high reactivity is less likely to be exposed (that is, chemical reactivity becomes insufficient). Therefore, the polishing rate for the insulating material can be adjusted by a balance between the ratio R and the crystallite diameter D of the cerium oxide particles. It is presumed that, when the product P of the ratio R and the crystallite diameter D of the cerium oxide particles is within a specific range, both physical polishing performance and chemical polishing performance can be obtained, and the polishing rate for the insulating material can be improved.

According to an aspect of the slurry according to the present embodiment, a low polishing rate for a stopper material can be obtained, and for example, a low polishing rate for silicon nitride can be obtained. According to an aspect of the slurry according to the present embodiment, for example, 500 nm/min or less (preferably, 400 nm/min or less, 300 nm/min or less, 200 nm/min or less, 150 nm/min or less, 130 nm/min or less, 120 nm/min or less, 110 nm/min or less, or the like) can be obtained as a polishing rate for a stopper material (for example, silicon nitride) in a method for evaluating a blanket wafer described in Examples described below.

According to an aspect of the slurry according to the present embodiment, it is possible to obtain a high polishing selection ratio of an insulating material to a stopper material (polishing rate for insulating material/polishing rate for stopper material), and for example, it is possible to obtain a high polishing selection ratio of silicon oxide to silicon nitride (polishing rate for silicon oxide/polishing rate for silicon nitride). According to an aspect of the slurry according to the present embodiment, for example, a polishing selection ratio of 2.0 or more (preferably, 3.0 or more, 4.0 or more, 5.0 or more, 5.5 or more, 6.0 or more, or the like) can be obtained in a method for evaluating a blanket wafer described in Examples described below.

According to the present embodiment, it is possible to provide a method for adjusting a polishing rate, the method including adjusting a polishing rate based on the product P of the ratio R of the peak intensity of the (200) plane to the peak intensity of the (111) plane of the cerium oxide particles and the crystallite diameter D of the (111) plane of the cerium oxide particles. According to the present embodiment, it is possible to provide a method for selecting abrasive grains, the method including selecting abrasive grains including cerium oxide particles based on the product P of the ratio R of the peak intensity of the (200) plane to the peak intensity of the (111) plane of the cerium oxide particles and the crystallite diameter D of the (111) plane of the cerium oxide particles. According to the present embodiment, it is possible to provide a use of a slurry for polishing a surface to be polished containing an insulating material, and it is possible to provide a use of a slurry for polishing a surface to be polished containing silicon oxide. According to the present embodiment, it is possible to provide a use of a slurry in a step of planarizing a base substrate surface, which is a semiconductor element manufacturing technique. According to the present embodiment, it is possible to provide a use of a slurry in a step of planarizing an STI insulating material, a pre-metal insulating material, or an interlayer insulating material.

(Abrasive Grains)

The slurry according to the present embodiment contains abrasive grains, and the abrasive grains include cerium oxide particles (particles containing cerium oxide). The cerium oxide of the cerium oxide particles may include tetravalent cerium or trivalent cerium.

The abrasive grains may include particles different from the cerium oxide particles. Examples of the particles different from the cerium oxide particles include silicon oxide (silica) particles, aluminum oxide (alumina) particles, silicon nitride particles, zirconium oxide (zirconia: yttria-added zirconia particles or the like) particles, titanium oxide (titania) particles, yttrium oxide (yttria) particles, silicon carbide particles, diamond particles, and polymer particles. The abrasive grains may be core-shell particles including core particles and cerium oxide particles fixed to surfaces of the core particles so as to partially cover the core particles, and may not be core-shell particles.

A content of cerium oxide (cerium oxide particles) may be in the following range based on the total mass of the abrasive grains (the total mass of the abrasive grains contained in the slurry). The content of cerium oxide (cerium oxide particles) may be 20 mass% or more, 30 mass% or more, 40 mass% or more, 50 mass% or more, more than 50 mass%, 60 mass% or more, 70 mass% or more, 80 mass% or more, 90 mass% or more, 95 mass% or more, 98 mass% or more, or 99 mass% or more, from the viewpoint of easily obtaining a high polishing rate for the insulating material. The abrasive grains contained in the slurry may be substantially formed of cerium oxide (cerium oxide particles) (a content of cerium oxide (cerium oxide particles) is substantially 100 mass% based on the total mass of the abrasive grains contained in the slurry). The content of cerium oxide (cerium oxide particles) satisfying at least one selected from the group consisting of the numerical range of the ratio R, the numerical range of the crystallite diameter D, and the numerical range of the product P described below may be within the range described above based on the total mass of the abrasive grains (the total mass of the abrasive grains contained in the slurry). When the abrasive grains further contain a component other than cerium oxide, the component other than cerium oxide may be a cerium compound other than cerium oxide or a compound containing a rare earth element (for example, a lanthanoid-based element) other than cerium. The abrasive grains may be composite oxide particles of cerium oxide and a compound containing a rare earth element (for example, a lanthanoid-based element) other than cerium, and may not be composite oxide particles of cerium oxide and a compound containing a rare earth element (for example, a lanthanoid-based element) other than cerium.

The cerium oxide particles can be obtained, for example, by oxidizing a cerium compound. Examples of a method for oxidizing a cerium compound include a firing method and an oxidation method using hydrogen peroxide or the like, and a firing method may be used from the viewpoint of easily obtaining a high polishing rate for the insulating material and easily suppressing a reduction in polishing rate with the progress of polishing. Examples of the cerium compound include cerium carbonate, cerium nitrate, cerium sulfate, cerium oxalate, and cerium acetate. From the viewpoint of easily obtaining a high polishing rate for the insulating material and easily suppressing a reduction in polishing rate with the progress of polishing, the cerium compound may be cerium carbonate, and the cerium oxide particles may include oxides derived from cerium carbonate.

Cerium carbonate for obtaining cerium oxide particles can be obtained using a natural mineral as a raw material, for example, by the following procedure. First, unnecessary gangue is removed from ore (bastnaesite ore, heavy sand, ankerite, or the like) containing at least a rare earth element containing cerium by a beneficiation treatment to obtain rare earth concentrate (bastnaesite concentrate, monazite concentrate, Chinese complex concentrate, or the like). Next, the rare earth concentrate is subjected to a chemical treatment (alkali decomposition, sulfuric acid decomposition, hydroxide fractionation precipitation method, or the like) to reduce insoluble components such as impurities, and then the rare earth elements (neodymium and the like) are reduced by solvent extraction as necessary, thereby obtaining a cerium-containing rare earth salt solution. Then, cerium carbonate can be obtained by mixing the cerium-containing rare earth salt solution with sodium carbonate. Such a method for producing cerium carbonate is defined as an "extraction method" for the sake of convenience.

Another cerium salt (cerium nitrate, cerium sulfate, cerium oxalate, cerium acetate, or the like) can be synthesized by changing the sodium carbonate used in the "extraction method " to another salt. For example, cerium nitrate (for example, cerium(III) nitrate) is obtained by mixing a cerium-containing rare earth salt solution and sodium nitrate. Cerium carbonate can be obtained by reacting an aqueous solution of a cerium salt with a solution of a precursor having a carbonyl group. For example, cerium carbonate can be precipitated by reacting an aqueous solution of cerium nitrate (for example, cerium(III) nitrate) with a solution of a precursor having a carbonyl group at a temperature of 80 to 100°C. As the precursor having a carbonyl group, urea or the like can be used. Such a method for producing cerium carbonate is defined as a "carbonyl substitution method" for the sake of convenience. The method for producing cerium carbonate in the present embodiment may be either the "extraction method" or the "carbonyl substitution method" from the viewpoint of easily obtaining a high polishing rate for the insulating material, and may be the "carbonyl substitution method" from the viewpoint of more easily obtaining a high polishing rate for the insulating material.

In the slurry according to the present embodiment, the abrasive grains include cerium oxide particles, and a product P of a ratio R of a peak intensity of a (200) plane to a peak intensity of a (111) plane in an X-ray diffraction measurement of the cerium oxide particles and a crystallite diameter D of the (111) plane of the cerium oxide particles is 7.5 to 11.0 nm. From the data obtained by powder X-ray diffraction (XRD) of the cerium oxide particles, the ratio R of the peak intensity of the (200) plane to the peak intensity of the (111) plane and the crystallite diameter D of the (111) plane of the cerium oxide particles can be derived. The crystallite diameter D of the (111) plane of the cerium oxide particles is calculated from Equation (1) for the peak of the (111) plane of the X-ray diffraction pattern (XRD chart) obtained by XRD of the cerium oxide particles. In Equation (1), K is a Schrrer constant, and 0.94 is used. $\lambda$ is a wavelength of incident X-rays, and 0.15418 nm is used in the case of $CuK\alpha$ rays. For B, a full width at half maximum (unit: radian) of the peak of the (111) plane is used. b is a full width at half maximum (unit: radian) of a peak when a width standard material $LaB_6$ (SRM660c) manufactured by NIST is measured with the same X-ray diffractometer. $\theta$ is a Bragg angle of the (111) plane.

[Formula 1]

$$D = \frac{K\lambda}{\sqrt{B^2 - b^2}\cos\theta} \qquad \text{Equation (1)}$$

The ratio R of the peak intensity of the (200) plane to the peak intensity of the (111) plane of the cerium oxide particles may be 0.200 or more, more than 0.200, 0.210 or more, 0.220 or more, 0.230 or more, 0.240 or more, 0.250 or more, more than 0.250, 0.260 or more, 0.265 or more, 0.270 or more, 0.280 or more, 0.290 or more, 0.300 or more, or more than 0.300, from the viewpoint of easily improving the chemical reactivity of the cerium oxide particles and easily improving the polishing rate for the insulating material. The ratio R may be 0.350 or less, less than 0.350, 0.340 or less, 0.330 or less, 0.320 or less, or 0.310 or less, from the viewpoint of easily increasing the physical strength of the cerium oxide particles and easily improving the polishing rate for the insulating material. The ratio R may be 0.300 or less, 0.290 or less, 0.280 or less, 0.270 or less, less than 0.270, 0.260 or less, 0.250 or less, or 0.240 or less. The ratio R may be 0.200 to 0.350, 0.200 to 0.330, 0.200 to 0.310, 0.220 to 0.350, 0.220 to 0.330, 0.220 to 0.310, 0.250 to 0.350, 0.250 to 0.330, 0.250 to 0.310, 0.290 to 0.350, 0.290 to 0.330, or 0.290 to 0.310.

The crystallite diameter D of the (111) plane of the cerium oxide particles may be 20.0 nm or more, 22.0 nm or more, 23.0 nm or more, 24.0 nm or more, 25.0 nm or more, 26.0 nm or more, 27.0 nm or more, 28.0 nm or more, or 29.0 nm or more, from the viewpoint of easily increasing the physical strength of the cerium oxide particles and easily improving the polishing rate for the insulating material. The crystallite diameter D may be 30.0 nm or more, 31.0 nm or more, 32.0 nm or more, or 33.0 nm or more. The crystallite diameter D may be 55.0 nm or less, 50.0 nm or less, 45.0 nm or less, 40.0 nm or less, less than 40.0 nm, 39.0 nm or less, 38.0 nm or less, 37.0 nm or less, 36.0 nm or less, 35.0 nm or less, less than 35.0 nm, 34.0 nm or less, or 33.0 nm or less, from the viewpoint of easily improving the chemical reactivity of the cerium oxide particles and easily improving the polishing rate for the insulating material. The crystallite diameter D may be 32.0 nm or less, 31.0 nm or less, 30.0 nm or less, or less than 30.0 nm. From these viewpoints, the crystallite diameter D may be 20.0 to 55.0 nm, 20.0 to 50.0 nm, 20.0 to 40.0 nm, 20.0 to 35.0 nm, 20.0 nm to 33.0 nm, 25.0 to 55.0 nm, 25.0 to 50.0 nm, 25.0 to 40.0 nm, 25.0 to 35.0 nm, 25.0 nm to 33.0 nm, 29.0 to 55.0 nm, 29.0 to 50.0 nm, 29.0 to 40.0 nm, 29.0 to 35.0 nm, or 29.0 nm to 33.0 nm.

The above-described numerical range for the ratio R of the peak intensity of the (200) plane to the peak intensity of the (111) plane of the cerium oxide particles can be arbitrarily combined with the above-described numerical range for the crystallite diameter D of the (111) plane of the cerium oxide particles. For example, the slurry according to the present embodiment may have an aspect in which the abrasive grains include cerium oxide particles, a crystallite diameter D of the (111) plane of the cerium oxide particles is 0.220 to 0.330, and the crystallite diameter D of the (111) plane of the cerium oxide particles is 25.0 to 35.0.

A method for adjusting the ratio R of the peak intensity of the (200) plane to the peak intensity of the (111) plane of the cerium oxide particles and the crystallite diameter D of the (111) plane of the cerium oxide particles includes a method of changing a composition of a raw material; a method of changing a raw material preparation method; a method of changing a firing temperature, a firing time, and the like when a raw material is fired in a firing method; and a method of changing a method, conditions, and the like of pulverization when cerium oxide particles are pulverized. These methods may be used alone or in combination.

The cerium oxide particles to be measured by XRD measurement for obtaining the ratio R of the peak intensity of the (200) plane to the peak intensity of the (111) plane of the cerium oxide particles and the crystallite diameter D of the (111) plane of the cerium oxide particles may be recovered by drying (drying and solidifying) the slurry, and may be recovered by separating and removing components other than the cerium oxide particles from the dried product. When the ratio R of the peak intensity of the (200) plane to the peak intensity of the (111) plane of the cerium oxide particles and the crystallite diameter D of the (111) plane of the cerium oxide particles do not vary in preparation of the slurry, the cerium oxide particles to be measured by XRD measurement may be cerium oxide particles before being mixed with other components such as water.

The product P of the ratio R and the crystallite diameter D of the cerium oxide particles may be 7.6 nm or more, 7.8 nm or more, 8.0 nm or more, 8.2 nm or more, 8.4 nm or more, 8.5 nm or more, 8.6 nm or more, 8.7 nm or more, 8.8 nm or more, or 8.9 nm or more, from the viewpoint of sufficiently increasing the chemical reactivity and physical strength of the cerium oxide particles and easily improving the polishing rate for the insulating material, and may be 10.8 nm or less, 10.6 nm or less, 10.5 nm or less, 10.4 nm or less, 10.2 nm or less, 10.0 nm or less, 9.8 nm or less, 9.6 nm or less, 9.5 nm or less, 9.4 nm or less, 9.3 nm or less, 9.2 nm or less, 9.1 nm or less, or 9.0 nm or less, from the same viewpoint. From these viewpoints, the product P may be 7.5 to 10.5 nm, 7.5 to 10.0 nm, 7.5 to 9.5 nm, 7.5 to 9.0 nm, 8.0 to 11.0 nm, 8.0 to 10.5 nm, 8.0 to 10.0 nm, 8.0 to 9.5 nm, 8.0 to 9.0 nm, 8.5 to 11.0 nm, 8.5 to 10.5 nm, 8.5 to 10.0 nm, 8.5 to 9.5 nm, or 8.5 to 9.0 nm.

A method for adjusting the product P of the ratio R and the crystallite diameter D of the cerium oxide particles includes a method of changing a composition of a raw material; a method of changing a raw material preparation method; a method of changing a firing temperature, a firing time, and the like when a raw material is fired in a firing method; and a method of changing a method, conditions, and the like of pulverization when cerium oxide particles are pulverized. These methods may be used alone or in combination. More specifically, for example, when the cerium oxide particles are wet-pulverized, the cerium oxide particles to be obtained are wet-pulverized so that an average particle diameter of the cerium oxide particles is reduced, such that the ratio R can be decreased without significantly changing the crystallite diameter D, and thus, the product P can be adjusted by adjusting the conditions of the wet-pulverization.

An average particle diameter D50 of the abrasive grains or an average particle diameter D50 of the cerium oxide particles may be in the following range. From the viewpoint of easily obtaining a high polishing rate for the insulating material, the average particle diameter D50 may be 80 nm or more, more than 80 nm, 90 nm or more, 100 nm or more, 120 nm or more, 140 nm or more, 150 nm or more, 150 nm, 160 nm or more, 170 nm or more, 180 nm or more, 190 nm or more, or 200 nm or more. From the viewpoint of easily reducing scratches caused by polishing, the average particle diameter D50 may be 600 nm or less, 500 nm or less, less than 500 nm, 400 nm or less, less than 400 nm, 350 nm or less, 300 nm or less, less than 300 nm, 290 nm or less, 280 nm or less, 270 nm or less, 260 nm or less, 250 nm or less, 240 nm or less, 230 nm or less, 220 nm or less, 210 nm or less, or 200 nm or less. From these viewpoints, the average particle diameter D50 may be 100 to 600 nm, 100 to 500 nm, 100 to 400 nm, 100 to 300 nm, 100 to 250 nm, 100 to 220 nm, 150 to 600 nm, 150 to 500 nm, 150 to 400 nm, 150 to 300 nm, 150 to 250 nm, 150 to 220 nm, 180 to 600 nm, 180 to 500 nm, 180 to 400 nm, 180 to 300 nm, 180 to 250 nm, or 180 to 220 nm.

The average particle diameter D50 means a value of MV (volume average diameter) measured by a laser diffraction particle diameter distribution meter, and can be measured, for example, by a method described in Examples described below. The measurement of the average particle diameter D50 (volume average diameter) may be performed by diluting the slurry with water to adjust the content of the abrasive grains or the content of the cerium oxide particles to an appropriate content, and for example, in the case of the trade name "SYNC" manufactured by MicrotracBEL Corp., the content may be adjusted to a diffraction volume (DV) value of 0.0010 to 0.0150. The DV value is a concentration index using the total amount of scattered light from the sample received by the detector, and tends to increase as the content of abrasive grains or the content of cerium oxide particles in the sample increases. In a case where a slurry containing abrasive grains (abrasive grains including cerium oxide particles), additives, and water is stored separately in a first liquid containing the abrasive grains and water and a second liquid containing the additives and water, a content of the abrasive grains may be adjusted to an appropriate content by diluting the first liquid with water, and an average particle diameter D50 may be measured.

Examples of a method for adjusting the average particle diameter D50 include adjustment of a composition, a preparation method, a firing temperature, a firing time, and the like of a raw material; pulverization; classification; and filtration. The pulverization, classification, and filtration may be performed on the abrasive grains or the cerium oxide particles, and may be performed on the raw material (cerium compound such as cerium carbonate) for obtaining cerium oxide particles.

The content of the abrasive grains in the slurry may be in the following range based on the total mass of the slurry. The content of the abrasive grains may be 0.01 mass% or more, 0.05 mass% or more, 0.10 mass% or more, 0.15 mass% or more, 0.30 mass% or more, 0.50 mass% or more, 0.80 mass% or more, 1.00 mass% or more, 1.20 mass% or more, 1.50 mass% or more, 1.80 mass% or more, or 2.00 mass% or more, from the viewpoint of easily obtaining a high polishing rate for the insulating material. The content of the abrasive grains may be 20.00 mass% or less, 15.00 mass% or less, 10.00 mass% or less, 8.00 mass% or less, 5.00 mass% or less, 4.50 mass% or less, 4.00 mass% or less, 3.50 mass% or less, 3.00 mass% or less, 2.50 mass% or less, or 2.00 mass% or less, from the viewpoint that aggregation of the particles is suppressed and the surface to be polished is hardly scratched. From these viewpoints, the content of the abrasive grains may be 0.01 to 20.00 mass%, 0.01 to 10.00 mass%, 0.01 to 5.00 mass%, 0.10 to 20.00 mass%, 0.10 to 10.00 mass%, 0.10 to 5.00 mass%, 0.50 to 20.00 mass%, 0.50 to 10.00 mass%, 0.50 to 5.00 mass%, 1.00 to 20.00 mass%, 1.00 to 10.00 mass%, or 1.00 to 5.00 mass%. In addition, the content of the cerium oxide particles in the slurry may be within the same range as the numerical range of the content of the abrasive grains described above.

(Water)

Water is not particularly limited, and examples thereof include deionized water and ultrapure water. A content of water may be a remainder of the slurry excluding the content of other constituent components, and is not particularly limited.

The content of water in the slurry may be in the following range based on the total mass of the slurry from the viewpoint of easily suppressing a reduction in polishing rate with the progress of polishing while obtaining a high polishing rate for the insulating material. The content of water may be 50 mass% or more, 70 mass% or more, 80 mass% or more, 90 mass% or more, 93 mass% or more, 95 mass% or more, 96 mass% or more, or 97 mass% or more. The content of water may be less than 100 mass%, 99 mass% or less, or 98 mass% or less. From these viewpoints, the content of water may be 50 mass% or more and less than 100 mass%, 50 to 99 mass%, 50 to 98 mass%, 80 mass% or more and less than 100 mass%, 80 to 99 mass%, 80 to 98 mass%, 90 mass% or more and less than 100 mass%, 90 to 99 mass%, or 90 to 98 mass%.

(Additives)

The slurry according to the present embodiment may contain optional additives and may not contain optional additives. Examples of the optional additives include a polar solvent (ethanol, acetone, or the like), a material having a carboxyl group (excluding a compound corresponding to a polyoxyalkylene compound or a water-soluble polymer), a polyoxyalkylene compound, a water-soluble polymer, an oxidant (for example, hydrogen peroxide), and a dispersant (for example, a phosphoric acid-based inorganic salt).

Examples of the material having a carboxyl group include monocarboxylic acids such as acetic acid, propionic acid, butyric acid, and valeric acid; hydroxy acids such as lactic acid, malic acid, and citric acid; dicarboxylic acids such as malonic acid, succinic acid, fumaric acid, and maleic acid; and amino acids such as arginine, histidine, and lysine.

Examples of the polyoxyalkylene compound include a polyalkylene glycol and a polyoxyalkylene derivative.

Examples of the polyalkylene glycol include polyethylene glycol, polypropylene glycol, and polybutylene glycol.

The polyoxyalkylene derivative is, for example, a compound obtained by introducing a functional group or a substituent into a polyalkylene glycol, or a compound obtained by adding a polyalkylene oxide to an organic compound. Examples of the functional group or the substituent include an alkyl ether group, an alkyl phenyl ether group, a phenyl ether group, a styrenated phenyl ether group, a glyceryl ether group, an alkyl amine group, a fatty acid ester group, and a glycol ester group. Examples of the polyoxyalkylene derivative include polyoxyethylene alkyl ether, polyoxyethylene bisphenol ether (for example, BA Glycol series, manufactured by Nippon Nyukazai Co., Ltd.), polyoxyethylene styrenated phenyl ether (for example, EMULGEN series, manufactured by Kao Corporation), polyoxyethylene alkylphenyl ether (for example, NOIGEN EA series, manufactured by DKS Co. Ltd.), polyoxyalkylene polyglyceryl ether (for example, SC-E series and SC-P series, manufactured by Sakamoto Yakuhin Kogyo Co., Ltd.), polyoxyethylene sorbitan fatty acid ester (for example, SORGEN TW series, manufactured by DKS Co. Ltd.), polyoxyethylene fatty acid ester (for example, EMANON series, manufactured by Kao Corporation), polyoxyethylene alkylamine (for example, AMILADIN D, manufactured by DKS Co. Ltd.), and other compounds to which a polyalkylene oxide is added (for example, SURFYNOL 465, manufactured by Nissin Chemical Industry Co., Ltd.; and TMP series, manufactured by Nippon Nyukazai Co., Ltd.).

The water-soluble polymer has an effect of adjusting dispersion stability and the like of the abrasive grains. The "water-soluble polymer" is defined as a polymer that dissolves in an amount of 0.1 g or more in 100 g of water. Note that a polymer corresponding to the polyoxyalkylene compound described above is not included in the "water-soluble polymer".

Examples of the water-soluble polymer include polycarboxylic acids such as polyacrylic acid and polymaleic acid; acrylic polymers such as polyacrylamide and polydimethylacrylamide; polysaccharides such as carboxymethylcellulose, agar, curdlan, dextrin, cyclodextrin, and pullulan; vinyl-based polymers such as polyvinyl alcohol, polyvinyl pyrrolidone, and polyacrolein; and glycerin-based polymers such as polyglycerin and a polyglycerin derivative.

A content of the water-soluble polymer may be in the following range based on the total mass of the slurry from the viewpoint of easily obtaining the addition effect of the water-soluble polymer while suppressing sedimentation of the abrasive grains. The content of the water-soluble polymer may be 0.001 mass% or more, 0.005 mass% or more, 0.010 mass% or more, 0.020 mass% or more, 0.030 mass% or more, 0.040 mass% or more, 0.050 mass% or more, 0.060 mass% or more, 0.070 mass% or more, or 0.075 mass% or more. The content of the water-soluble polymer may be 10.000 mass% or less, 8.000 mass% or less, 6.000 mass% or less, 5.000 mass% or less, 3.000 mass% or less, 1.000 mass% or less, 0.500 mass% or less, 0.300 mass% or less, 0.100 mass% or less, 0.080 mass% or less, or 0.075 mass% or less. From these viewpoints, the content of the water-soluble polymer may be 0.001 to 10.000 mass%, 0.001 to 1.000 mass%, 0.001 to 0.500 mass%, 0.001 to 0.100 mass%, 0.010 to 10.000 mass%, 0.010 to 1.000 mass%, 0.010 to 0.500 mass%, 0.010 to 0.100 mass%, 0.030 to 10.000 mass%, 0.030 to 1.000 mass%, 0.030 to 0.500 mass%, 0.030 to 0.100 mass%, 0.050 to 10.000 mass%, 0.050 to 1.000 mass%, 0.050 to 0.500 mass%, or 0.050 to 0.100 mass%.

(pH)

A pH of the slurry according to the present embodiment may be in the following range. The pH may be less than 7.00, 6.50 or less, less than 6.50, 6.00 or less, less than 6.00, 5.50 or less, less than 5.50, 5.00 or less, less than 5.00, 4.90 or less, 4.85 or less, or 4.80 or less, from the viewpoint of easily obtaining a high polishing rate for the insulating material. Since the pH of the slurry is less than 7 (that is, acidic) and the product P of the cerium oxide particles contained in the slurry falls within the numerical range of the product P described above, it is possible to polish the insulating material at a higher polishing rate than the slurry containing the cerium oxide particles having a pH of 7 or more and having a product P falling within the numerical range of the product P described above and the slurry containing the cerium oxide particles having a pH of less than 7 and having a product P falling outside the numerical range of the product P described above. When the pH of the slurry is less than 7, the surface of the cerium oxide particles is positively charged and the surface of the insulating material is negatively charged. Since an electrostatic attractive force is generated between the cerium oxide particles and the insulating material, a proportion of the cerium oxide particles contributing to polishing increases. As a result, the insulating material can be polished at a higher polishing rate. The pH may be 4.75 or less, 4.70 or less, 4.65 or less, 4.60 or less, 4.55 or less, 4.50 or less, less than 4.50, 4.45 or less, 4.40 or less, 4.35 or less, 4.30 or less, 4.25 or less, 4.20 or less, 4.10 or less, 4.00 or less, or 3.90 or less. The pH may be 1.00 or more, 1.50 or more, 2.00 or more, 2.50 or more, 3.00 or more, more than 3.00, 3.10 or more, 3.20 or more, 3.30 or more, 3.40 or more, 3.50 or more, more than 3.50, 4.00 or more, more than 4.00, 4.10 or more, or 4.20 or more, from the viewpoint of easily obtaining a high polishing rate for the insulating material. The pH may be 4.30 or more, 4.40 or more, 4.50 or more, more than 4.50, 4.60 or more, 4.70 or more, or 4.80 or more. From these viewpoints, the pH may be 1.00 or more and less than 7.00, 1.00 to 6.00, 1.00 to 5.00, 1.00 to 4.80, 2.00 or more and less than 7.00, 2.00 to 6.00, 2.00 to 5.00, 2.00 to 4.80, 3.00 or more and less than 7.00, 3.00 to 6.00, 3.00 to 5.00, 3.00 to 4.80, 3.30 or more and less than 7.00, 3.30 to 6.00, 3.30 to 5.00, 3.30 to 4.80, 4.00 or more and less than 7.00, 4.00 to 6.00, 4.00 to 5.00, or 4.00 to 4.80. The pH of the slurry is defined as the pH at a liquid temperature of 25°C.

The pH of the slurry can be adjusted by an acid component such as an inorganic acid or an organic acid; an alkaline component such as ammonia, sodium hydroxide, tetramethylammonium hydroxide (TMAH), imidazole, or alkanolamine; and the like. In order to stabilize the pH, a buffering agent may be added, and a buffer solution (a liquid containing a buffering agent) may be added. Examples of the buffer solution include an acetate buffer solution and a phthalate buffer solution.

The pH of the slurry according to the present embodiment can be measured with a pH meter (for example, model number PHL-40, manufactured by DKK-TOA CORPORATION). For example, after a pH meter is calibrated at two points using a phthalate pH buffer solution (pH: 4.01) and a neutral phosphate pH buffer solution (pH: 6.86) as standard buffer solutions, an electrode of the pH meter is placed in the slurry, and a value after stabilization for 2 minutes or longer can be measured as the pH of the slurry. Liquid temperatures of the standard buffer solution and the slurry are both 25°C.

(Storage Mode)

When the slurry according to the present embodiment contains the optional additives described above, the slurry according to the present embodiment may be stored in a one-liquid state containing abrasive grains, additives, and water, and may be stored as a set of a plurality of liquids (for example, two liquids) in which constituent components of the slurry are divided into a first liquid and a second liquid so that the first liquid containing abrasive grains and water and the second liquid containing additives and water are mixed to form a slurry. The slurry according to the present embodiment may be in a one-liquid state containing abrasive grains, additives, and water, or may be a first liquid in a plurality of liquid sets. The second liquid may contain at least one of the additives, and the first liquid may contain additives of the same types as or different types from the additives of the second liquid. The constituent components of the slurry may be stored in three or more liquids.

In the plurality of liquid sets described above, the first liquid and the second liquid are mixed immediately before polishing or during polishing to prepare a slurry. The one-liquid slurry may be stored as a storage liquid in which a content of water is reduced, and may be diluted with water at the time of polishing and used. In the plurality of liquid sets, the first liquid and the second liquid are stored as a storage liquid in which a content of water is reduced, and may be used by being diluted with water at the time of polishing.

<Polishing Method>

A polishing method according to the present embodiment (a method for polishing a base substrate or the like) includes a polishing step of polishing a surface to be polished (a surface to be polished of a base substrate or the like) using the slurry according to the present embodiment. The slurry in the polishing step may be a slurry obtained by mixing the first liquid and the second liquid in the plurality of liquid sets described above.

In the polishing step, for example, the slurry according to the present embodiment may be supplied between a material to be polished and a polishing pad in a state where an insulating material of a base substrate having the insulating material is pressed against the polishing pad (polishing cloth) of a polishing platen, and a surface to be polished of the insulating material may be polished by relatively moving the base substrate and the polishing platen. In the polishing step, for example, at least a part of the insulating material is removed by polishing.

Examples of an object to be polished include a base substrate to be polished. Examples of the substrate to be polished include a base substrate in which an insulating material is formed on a substrate (for example, a semiconductor substrate on which an STI pattern, a gate pattern, a wiring pattern, and the like are formed) related to semiconductor element manufacturing. Examples of the insulating material include silicon oxide. The insulating material may be a single material or a plurality of materials. When a plurality of materials are exposed on a surface to be polished, these materials can be regarded as insulating materials. The insulating material may be a film-like (insulating film) or a silicon oxide film.

By polishing the insulating material (for example, silicon oxide) formed on the substrate using the slurry according to the present embodiment to remove an excess portion, irregularities formed on the surface of the insulating material are eliminated, and a smooth surface can be obtained over the entire surface of the insulating material.

In the polishing method according to the present embodiment, a general polishing apparatus including a holder capable of holding a base substrate having a surface to be polished and a polishing platen to which a polishing pad can be attached can be used as a polishing apparatus. A motor or the like capable of changing a rotational speed may be attached to each of the holder and the polishing platen.

As the polishing pad, a general non-woven fabric, foam, non-foam, or the like can be used. As a material of the polishing pad, a resin such as polyurethane, an acrylic resin, polyester, an acryl-ester copolymer, polytetrafluoroethylene, polypropylene, polyethylene, poly 4-methylpentene, cellulose, cellulose ester, polyamide (for example, Nylon (trade name) and aramid), polyimide, polyimide-amide, a polysiloxane copolymer, an oxirane compound, a phenolic resin, polystyrene, polycarbonate, or an epoxy resin can be used. The material of the polishing pad may be at least one selected from the group consisting of foamed polyurethane and non-foamed polyurethane from the viewpoint of easily obtaining excellent polishing rate and flatness. The polishing pad may be subjected to grooving so that the slurry accumulates.

The polishing conditions are not limited, and an upper limit of a rotational speed of the polishing platen may be 200 $min^{-1}$ ($min^{-1}$ = rpm) or less so that the base substrate does not jump out, and an upper limit of a polishing pressure (processing load) applied to the base substrate may be 100 kPa or less from the viewpoint of easily suppressing the occurrence of polishing scratches. During polishing, the slurry may be continuously supplied to the polishing pad by a pump or the like. The amount of the slurry supplied in this case is not limited, and the surface of the polishing pad may be always covered with the slurry.

The slurry and the polishing method according to the present embodiment may be used to polish a surface to be polished containing silicon oxide. The slurry and the polishing method according to the present embodiment can be suitably used for formation of STI and high-rate polishing of an interlayer insulating material. In such silicon oxide, some of the constituent elements may be substituted with a carbon atom, a nitrogen atom, a phosphorus atom, a boron atom, or the like.

The slurry and the polishing method according to the present embodiment can also be used for polishing a pre-metal insulating material. Examples of the pre-metal insulating material include silicon oxide, phosphorus-silicate glass, boron-phosphorus-silicate glass, silicon oxyfluoride, and fluorinated amorphous carbon.

The slurry and the polishing method according to the present embodiment can also be applied to a material other than the insulating material such as silicon oxide. Examples of such a material include high dielectric constant materials such as Hf-based, Ti-based, and Ta-based oxides; semiconductor materials such as silicon, amorphous silicon, SiC, SiGe, Ge, GaN, GaP, GaAs, and an organic semiconductor; phase change materials such as GeSbTe; inorganic conductive materials such as ITO; and polymer resin materials such as polyimide-based, polybenzoxazole-based, acryl, epoxy-based, and phenolic materials.

The slurry and the polishing method according to the present embodiment can be applied not only to a film-like object to be polished but also to various substrates formed of glass, silicon, SiC, SiGe, Ge, GaN, GaP, GaAs, sapphire, plastic, and the like.

The slurry and the polishing method according to the present embodiment can be used not only in manufacturing a semiconductor element but also in an image display device such as a TFT or an organic EL; an optical component such as a photomask, a lens, a prism, an optical fiber, or a single crystal scintillator; an optical element such as an optical switching element or an optical waveguide; a light emitting element such as a solid laser or a blue laser LED; and a magnetic storage device such as a magnetic disk or a magnetic head.

<Manufacturing Method and The Like>

A method for manufacturing a component according to the present embodiment includes a component preparation step of obtaining a component using a base substrate (member to be polished) polished by the polishing method according to the present embodiment. The component according to the present embodiment is a component obtained by the method for manufacturing a component according to the present embodiment. The component according to the present embodiment is not particularly limited, and may be an electronic component (for example, a semiconductor component such as a semiconductor package), a wafer (for example, a semiconductor wafer), or a chip (for example, a semiconductor chip). As an aspect of the method for manufacturing a component according to the present embodiment, in a method for manufacturing an electronic component according to the present embodiment, an electronic component is obtained using a base substrate polished by the polishing method according to the present embodiment. As an aspect of the method for manufacturing a component according to the present embodiment, in a method for manufacturing a semiconductor component according to the present embodiment, a semiconductor component (for example, a semiconductor package) is obtained using a base substrate polished by the polishing method according to the present embodiment. The method for manufacturing a component according to the present embodiment may include a polishing step of polishing a base substrate by the polishing method according to the present embodiment before the component preparation step.

The method for manufacturing a component according to the present embodiment may include, as an aspect of the component preparation step, a segmentation step of segmenting a base substrate (member to be polished) polished by the polishing method according to the present embodiment. The segmentation step may be, for example, a step of dicing a wafer (for example, a semiconductor wafer) polished by the polishing method according to the present embodiment to obtain a chip (for example, a semiconductor chip). As an aspect of the method for manufacturing a component according to the present embodiment, the method for manufacturing an electronic component according to the present embodiment may include a step of obtaining an electronic component (for example, a semiconductor component) by segmenting a base substrate polished by the polishing method according to the present embodiment. As an aspect of the method for manufacturing a component according to the present embodiment, the method for manufacturing a semiconductor component according to the present embodiment may include a step of obtaining a semiconductor component (for example, a semiconductor package) by segmenting a base substrate polished by the polishing method according to the present embodiment.

The method for manufacturing a component according to the present embodiment may include a connection step of connecting (for example, electrically connecting) a base substrate (member to be polished) polished by the polishing method according to the present embodiment and another body to be connected as an aspect of the component preparation step. The body to be connected to the base substrate polished by the polishing method according to the present embodiment is not particularly limited, and may be a base substrate polished by the polishing method according to the present embodiment, or may be a body to be connected different from the base substrate polished by the polishing method according to the present embodiment. In the connection step, the base substrate and the body to be connected may be directly connected (connected in a state where the base substrate and the body to be connected are in contact with each other), or the base substrate and the body to be connected may be connected via another member (conductive member or the like). The connection step can be performed before the segmentation step, after the segmentation step, or before and after the segmentation step.

The connection step may be a step of connecting a surface to be polished of the base substrate polished by the polishing method according to the present embodiment and the body to be connected, or may be a step of connecting a connection surface of the base substrate polished by the polishing method according to the present embodiment and a connection surface of the body to be connected. The connection surface of the base substrate may be the surface to be polished, which is polished by the polishing method according to the present embodiment. By the connection step, a connection body including a base substrate and a body to be connected can be obtained. In the connection step, when the connection surface of the base substrate has a metal portion, the body to be connected may be brought into contact with the metal portion. In the connection step, when the connection surface of the base substrate has the metal portion and the connection surface of the body to be connected has the metal portion, the metal portions may be brought into contact with each other. The metal portion may contain copper.

A device (for example, an electronic device such as a semiconductor device) according to the present embodiment includes at least one selected from the group consisting of a base substrate polished by the polishing method according to the present embodiment and a component according to the present embodiment.

[Examples]

Hereinafter, the present disclosure will be specifically described with reference to Examples, and the present disclosure is not limited to the following Examples.

<Preparation of Slurry>

(Example 1)

Based on the "carbonyl substitution method" described above, 0.1 mol/L of a cerium(III) nitrate aqueous solution and 7.8 mol/L of a urea aqueous solution were mixed at a volume ratio of 6:1 while maintaining the temperature at 95°C to generate a precipitate of cerium carbonate. The precipitate was filtered and dried to obtain a cerium carbonate powder (raw material). The cerium carbonate powder was placed in an alumina container, and the cerium carbonate powder was fired in the air at a firing temperature of 700°C for 1 hour using an oven "HPM-2N" manufactured by AS ONE Corporation to obtain a white powder. Phase identification of the powder was performed by XRD, and it was confirmed that the powder was a powder of cerium oxide.

The cerium oxide powder was crushed in a mortar, and then passed through a sieve with a mesh size of 450 $\mu$m to obtain a crushed product. The crushed product, pure water, and acetic acid were mixed at a mass ratio of 20.00:79.94:0.06 to obtain a mixture, and then the mixture was subjected to a wet pulverization treatment using a wet-type pulverizing device "Star Burst Labo HJP-25005" (pressure 245 MPa) manufactured by SUGINO MACHINE LIMITED CO., LTD. to obtain a dispersion. The wet pulverization was performed so that an average particle diameter D50 of the pulverized product (cerium oxide particles) in the dispersion was 400 nm. The dispersion was centrifuged using a centrifuge "himac CR7" (rotational speed: 2,000 rpm) manufactured by Hitachi Koki Co., Ltd., and a dispersion containing cerium oxide particles was obtained as a liquid retained in the upper portion of the container after the centrifugation. The centrifugation was performed so that the cerium oxide particles in the obtained dispersion had an average particle diameter D50 of 200 nm. Thereafter, the cerium oxide particles were recovered from the dispersion.

The cerium oxide particles (abrasive grains), pure water, and polyglycerin (trade name: Polyglycerin #750, manufactured by Sakamoto Yakuhin Kogyo Co., Ltd.) were mixed at a mass ratio of 2.000:97.925:0.075 to obtain a polishing slurry. An average particle diameter D50 of the cerium oxide particles in the slurry was 200 nm.

(Example 2)

A slurry for polishing was obtained in the same manner as that of Example 1, except that the wet pulverization was performed so that the average particle diameter D50 of the pulverized product (cerium oxide particles) in the dispersion was 300 nm. An average particle diameter D50 of the cerium oxide particles in the slurry was 200 nm.

(Example 3)

Based on the "extraction method" described above, 0.1 mol/L of a cerium(III) sulfate aqueous solution and 0.1 mol/L of a sodium carbonate aqueous solution were mixed at a volume ratio of 1:2 while maintaining the temperature at 95°C to generate a precipitate of cerium carbonate. The precipitate was filtered and dried to obtain a cerium carbonate powder (raw material). The cerium carbonate powder was placed in an alumina container, and the cerium carbonate powder was fired in the air at a firing temperature of 800°C for 1 hour using an oven "HPM-2N" manufactured by AS ONE Corporation to obtain a white powder. Phase identification of the powder was performed by XRD, and it was confirmed that the powder was a powder of cerium oxide.

The cerium oxide powder was crushed in a mortar, and then passed through a sieve with a mesh size of 450 $\mu$m to obtain a crushed product. The crushed product, pure water, and acetic acid were mixed at a mass ratio of 20.00:79.94:0.06 to obtain a mixture, and then the mixture was subjected to a wet pulverization treatment using a wet-type pulverizing device "Star Burst Labo HJP-25005" (pressure 245 MPa) manufactured by SUGINO MACHINE LIMITED CO., LTD. to obtain a dispersion. The wet pulverization was performed so that an average particle diameter D50 of the pulverized product (cerium oxide particles) in the dispersion was 400 nm. The dispersion was centrifuged using a centrifuge "himac CR7" (rotational speed: 2,000 rpm) manufactured by Hitachi Koki Co., Ltd., and a dispersion containing cerium oxide particles was obtained as a liquid retained in the upper portion of the container after the centrifugation. The centrifugation was performed so that the cerium oxide particles in the obtained dispersion had an average particle diameter D50 of 200 nm. Thereafter, the cerium oxide particles were recovered from the dispersion.

The cerium oxide particles (abrasive grains), pure water, and polyglycerin (trade name: Polyglycerin #750, manufactured by Sakamoto Yakuhin Kogyo Co., Ltd.) were mixed at a mass ratio of 2.000:97.925:0.075 to obtain a polishing slurry. An average particle diameter D50 of the cerium oxide particles in the slurry was 200 nm.

(Example 4)

A slurry for polishing was obtained in the same manner as that of Example 2, except that the firing temperature was changed to 850°C and the firing time was changed to 3 hours. An average particle diameter D50 of the cerium oxide particles in the slurry was 200 nm.

(Comparative Example 1)

A slurry for polishing was obtained in the same manner as that of Example 1, except that the cerium carbonate powder was changed to cerium acetate (Kanto Chemical CO., INC., trade name: cerium(III) acetate monohydrate, 4 N (cerous acetate)). An average particle diameter D50 of the cerium oxide particles in the slurry was 200 nm.

(Comparative Example 2)

A slurry for polishing was obtained in the same manner as that of Example 1, except that the cerium carbonate powder was changed to cerium acetate (Kanto Chemical CO., INC., trade name: cerium(III) acetate monohydrate, 4 N (cerous acetate)), and the firing temperature was changed to 850°C. An average particle diameter D50 of the cerium oxide particles in the slurry was 200 nm.

(Comparative Example 3)

A slurry for polishing was obtained in the same manner as that of Example 3, except that the wet pulverization was performed so that the average particle diameter D50 of the pulverized product (cerium oxide particles) in the dispersion was 300 nm. An average particle diameter D50 of the cerium oxide particles in the slurry was 200 nm.

(Comparative Example 4)

A slurry for polishing was obtained in the same manner as that of Example 3, except that the firing temperature was changed to 900°C. An average particle diameter D50 of the cerium oxide particles in the slurry was 200 nm.

<Average Particle Diameter>

The average particle diameter D50 of the cerium oxide particles was measured as a volume average diameter (MV) using a laser diffraction particle diameter analyzer (trade name "SYNC", manufactured by MicrotracBEL Corp., particle refractive index: 2.20).

<Ratio of Peak Intensity and Crystallite Diameter D>

Each of the slurries described above was placed in a commercially available evaporating dish, and then dried and solidified in a vacuum dryer (ADP200, manufactured by Yamato Scientific Co., Ltd., 40°C, about 1,000 Pa) for 24 hours to obtain a dried and solidified product. The dried and solidified product was crushed in a mortar, and then subjected to XRD measurement under the following conditions to obtain an X-ray diffraction pattern. From the obtained X-ray diffraction pattern, a ratio R of a peak intensity of a (200) plane to a peak intensity of a (111) plane of the cerium oxide particle (peak intensity of (200) plane/peak intensity of (111) plane) was calculated. In addition, a crystallite diameter D of the (111) plane was calculated based on Equation (1) described above. Note that, in Equation (1), the Scherrer constant K is 0.94, the wavelength $\lambda$ of the X-ray is 0.15418 nm, B is the full width at half maximum (unit: radian) of the peak of the (111) plane, b is the full width at half maximum (unit: radian) of the peak when the width standard material $LaB_6$ (SRM660c) manufactured by NIST is measured with the same X-ray diffractometer, and the Bragg angle $\theta$ is half of the value of the (111) peak position ($2\theta$).

[XRD Measurement Conditions]

XRD apparatus: horizontal sample type multi-purpose X-ray diffractometer Ultima IV (manufactured by Rigaku Corporation)
X-ray source: CuK$\alpha$ ray
Scanning mode: $2\theta/\theta$
X-ray tube voltage: 40 kV
X-ray tube current: 40 mA
Divergence slit: 1 deg
Divergence vertical restriction slit: 10 mm
Scattering slit: 1 deg
Light receiving slit: 0.15 mm
K$\beta$ filter: none (using counter monochromator)
Scanning range: 3 to 90 deg
Step: 0.01 deg
Scanning speed: 0.5 deg/min

<pH of Slurry>

The pH (25°C) of each of the slurries described above was measured using model number PHL-40 manufactured by DKK-TOA CORPORATION. The measurement results are shown in Table 1.

<CMP Evaluation>

Using each of the slurries described above, CMP evaluation was performed under the following conditions.

(Preparation of Wafer for Evaluation)

As a blanket wafer (BKW), a 20 mm × 20 mm non-patterned wafer having a silicon oxide film (TEOS, initial film thickness: 1,000 nm) formed on a surface thereof and a 20 mm × 20 mm non-patterned wafer having a silicon nitride film (initial film thickness: 200 nm) formed on a surface thereof were prepared.

As a patterned wafer (PTW), a test patterned wafer (model number: Sematech864, manufactured by Advantec Co., Ltd., 20 mm × 20 mm) of a silicon oxide film (initial film thickness: 600 nm) having an uneven pattern formed on a surface thereof was prepared. A convex portion (line portion) has an initial step that is 500 nm higher than a concave portion (space portion), and the convex portion includes a silicon nitride film (initial film thickness: 140 nm) as a stopper for the base of the silicon oxide film assuming evaluation for shallow trench isolation. The patterned wafer has a plurality of 20 mm × 20 mm die units, and has a plurality of 4 mm × 4 mm unit areas in each die unit. The patterned wafer has, as a 4 mm × 4 mm unit area, a region having parallel line patterns with a pitch with a width of 100 μm and a line/space (L/S) of 10 μm/90 μm (density of convex portions: 10%) to 90 μm/10 μm (density of convex portions: 90%) in increments of 10 μm.

(Polishing Conditions)

Polishing apparatus: small-sized bench type polishing machine ("IMPTECH 10 DVT", manufactured by ENGIS JAPAN Corporation)
Polishing cloth: polishing pad formed of porous urethane resin (model number: IK4250H, manufactured by DuPont (Dow))
Rotational speed of platen: 120 min$^{-1}$
Polishing pressure: 50 kPa
Amount of polishing liquid supplied: 5 ml/min

(Polishing Procedure)

The blanket wafer was polished for 30 seconds. In the patterned wafer, a time during which the silicon nitride film as the base of the silicon oxide film was not exposed at the convex portion in the region of L/S = 20 μm/80 μm was set as a polishing time in a range of 20 to 60 seconds according to the polishing rate evaluated with the blanket wafer, and polishing was performed with the polishing time.

(Evaluation of Polishing Rate)

A film thickness variation of the film to be polished before and after polishing was measured as follows using a light interference type film thickness measuring apparatus (trade name: AFT-5100, manufactured by Nanometrics Japan Ltd.), and a polishing rate was obtained. The results are shown in Table 1.

In the blanket wafer, the film thickness variation was measured at the center point of the wafer. The film thickness variation in the polishing time for 30 seconds was measured, and the average value thereof was obtained as the polishing rate for the blanket wafer.

For the patterned wafer, the film thickness variation at the convex portion in the region of L/S = 20 μm/80 μm was measured to obtain a polishing rate for the patterned wafer. The film thickness variation at one central portion of one unit area (4 mm × 4 mm) of L/S = 20 μm/80 μm was measured.

[Table 1]

| | Example 1 | Example 2 | Example 3 | Example 4 | Comparative Example 1 | Comparative Example 2 | Comparative Example 3 | Comparative Example 4 |
|---|---|---|---|---|---|---|---|---|
| Ratio R of peak intensity of (200) plane to peak intensity of (111) plane | 0.304 | 0.263 | 0.301 | 0.343 | 0.298 | 0.359 | 0.238 | 0.335 |
| Crystallite diameter D of (111) plane [nm] | 29.4 | 30.1 | 33.0 | 30.2 | 20.6 | 31.8 | 30.3 | 35.4 |
| Product P of ratio R and crystallite diameter D [nm] | 8.9 | 7.9 | 9.9 | 10.4 | 6.1 | 11.4 | 7.2 | 11.9 |
| pH | 4.4 | 4.4 | 4.8 | 4.2 | 4.0 | 3.8 | 4.8 | 4.0 |
| Polishing rate [nm/min] Silicon oxide (BKW) | 994 | 775 | 656 | 764 | 31 | 43 | 428 | 433 |
| Silicon nitride (BKW) | 194 | 137 | 107 | - | 29 | 33 | - | - |
| Silicon oxide (PTW) | 1577 | 268 | 646 | - | 47 | 58 | - | - |

**Claims**

1. A slurry comprising abrasive grains and water,

   wherein the abrasive grains comprise cerium oxide particles, and
   a product P of a ratio R of a peak intensity of a (200) plane to a peak intensity of a (111) plane of the cerium oxide particles in an X-ray diffraction measurement and a crystallite diameter D of the (111) plane of the cerium oxide particles is 7.5 to 11.0 nm.

2. The slurry according to claim 1, wherein the ratio R is 0.220 to 0.330.

3. The slurry according to claim 1, wherein the ratio R is 0.265 or more.

4. The slurry according to claim 1, wherein the crystallite diameter D is 25.0 to 35.0 nm.

5. The slurry according to claim 1, wherein the product P is 8.5 to 10.0 nm.

6. The slurry according to claim 1, wherein a content of the abrasive grains is 0.01 to 10.00 mass%.

7. The slurry according to claim 1, wherein a pH of the slurry is less than 7.00.

8. The slurry according to claim 1, wherein the slurry is used for polishing a surface to be polished comprising silicon oxide.

9. A polishing method comprising a step of polishing a surface to be polished using the slurry according to any one of claims 1 to 8.

## INTERNATIONAL SEARCH REPORT

| | International application No. |
|---|---|
| | **PCT/JP2024/019757** |

**A.  CLASSIFICATION OF SUBJECT MATTER**

*H01L 21/304*(2006.01)i
FI:   H01L21/304 622D

According to International Patent Classification (IPC) or to both national classification and IPC

**B.  FIELDS SEARCHED**

Minimum documentation searched (classification system followed by classification symbols)

H01L21/304

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C.  DOCUMENTS CONSIDERED TO BE RELEVANT**

| Category* | Citation of document, with indication, where appropriate, of the relevant passages | Relevant to claim No. |
|---|---|---|
| X | JP 2009-51726 A (HITACHI CHEMICAL CO., LTD.) 12 March 2009 (2009-03-12) | 1-6, 8-9 |
| | paragraphs [0001]-[0120] | |
| Y | paragraphs [0001]-[0120] | 7 |
| Y | JP 2017-186196 A (JSR CORPORATION) 12 October 2017 (2017-10-12) | 7 |
| | paragraphs [0001]-[0052], fig. 1 | |
| A | JP 2000-188270 A (HITACHI CHEMICAL CO., LTD.) 04 July 2000 (2000-07-04) | 1-9 |
| | entire text, all drawings | |

☐ Further documents are listed in the continuation of Box C.        ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **07 August 2024** | **20 August 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

International application No.

**PCT/JP2024/019757**

| Patent document cited in search report | | | Publication date (day/month/year) | Patent family member(s) | Publication date (day/month/year) |
|---|---|---|---|---|---|
| JP | 2009-51726 | A | 12 March 2009 | US 6615499 B1 column 1, line 22 to column 14, line 64 EP 1201607 A1 KR 10-2005-0039789 A | |
| JP | 2017-186196 | A | 12 October 2017 | (Family: none) | |
| JP | 2000-188270 | A | 04 July 2000 | (Family: none) | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H10106994 A
- JP H08022970 A